# DEMANDE DE BREVET EUROPEEN

(11) **EP 3 370 257 A1**
(43) Date de publication de la demande: **05.09.2018**
(21) Numéro de dépôt: 18158413.7
(22) Date de dépôt: 23.02.2018
(51) Int. Cl.: H01L 27/12, H01L 29/786, H01L 21/477, H01L 21/02

(54) **DIMINUTION DE LA TEMPERATURE DE RECUIT DE COUCHE IGZO OBTENUE PAR SOL GEL**

(30) Priorité: 01.03.2017 FR 1751675
(71) Demandeur: Commissariat à l'énergie atomique et aux énergies alternatives, 75015 Paris (FR)
(72) Inventeur: BENWADIH, Mohammed, 94500 CHAMPIGNY SUR MARNE (FR); REVENANT-BRIZARD, Christine, 38000 GRENOBLE (FR)
(74) Mandataire: Brevalex

(57) **Abrégé**

La présente demande concerne un procédé de formation d'une zone active d'oxyde métallique pour composant électronique comprenant la formation d'un empilement de couches d'IXZO (9₁, 9₂, 9₃) réalisées par dépôt en phase liquide sur un substrat, les couches de cet empilement ayant des fractions atomiques différentes entre elles afin de permettre de diminuer la température de recuit permettant de les rendre fonctionnelles.

## Description

### DOMAINE TECHNIQUE ET ART ANTÉRIEUR

La présente demande est relative au domaine des transistors en couches minces (TFT pour « Thin-film transistor » c'est à dire « transistor couche mince »), en particulier ceux doté d'une couche active à base d'oxyde métallique telle que l'IGZO (pour « Indium Gallium Zinc Oxide » i.e. Indium Gallium et Oxyde de Zinc »).

Comme pour un transistor classique, dans un transistor TFT la conduction s'effectue dans un couche mince dite « couche active » entre une électrode de source et une électrode de drain et dont la conductivité est modulée par une électrode grille.

Il existe actuellement des transistors TFT dont la couche active est à base de silicium amorphe hydrogéné (a-Si:H) ou de silicium polycristallin (poly-Si). Des transistors TFT dont la couche active est en un oxyde métallique tel que de l'IGZO sont également apparus. Un tel matériau présente l'avantage d'avoir une mobilité des porteurs de charge supérieure à celle du silicium amorphe ou du polysilicium.

Une technique connue pour former des couches à base d'IGZO est le dépôt PVD (pour « Physical Vapor Deposition ») et plus particulièrement la pulvérisation cathodique.

Une telle méthode nécessite l'établissement d'un vide poussé, peut engendrer des non-uniformités de composition, et peut s'avérer onéreuse.

Une méthode alternative pour réaliser une couche active d'IGZO est la voie liquide, et notamment en utilisant un procédé par jet d'encre.

L'encre est disposée sur un support puis séchée. Afin d'obtenir un oxyde, une étape de recuit haute température, typiquement réalisée à une température supérieure à 400°C est ensuite mise en oeuvre. De telles températures peuvent s'avérer incompatibles avec la mise en oeuvre sur certains supports et en particulier sur des supports en polymère.

Le document "Flexible metal-oxide devices made by room-temperature photochemical activation of sol-gel films", de Y.-H. Kim et al., Nature, vol. 489, no. 7414, p. 128-132, 2012 prévoit la réalisation d'une couche active d'IGZO par voie liquide en utilisant une solution de dépôt que l'on transforme par effet photochimique en effectuant un recuit assisté par UV. Une telle technique permet de rendre actif l'oxyde métallique tout en limitant les températures de recuit.

Le document "Low-temperature fabrication of high performance metal oxide thin-film electronics via combustion processing", de M.-G. Kim et al., prévoit la mise en oeuvre d'une couche d'oxyde métallique basée sur une réaction d'oxydoréduction entre des nitrates et un carburant organique. Cette réaction exothermique, entraine une réaction plus rapide en consommant tous les réactifs à plus basse température. La technique présentée parait permettre de diminuer la température de recuit nécessaire à l'activation de la couche d'oxyde métallique.

Il se pose le problème de trouver un nouveau procédé de réalisation d'une couche à base d'oxyde métallique de type IXZO dans lequel la température de recuit nécessaire à son activation serait limitée.

### EXPOSÉ DE L'INVENTION

Les inventeurs ont découverts que le fait de réaliser un empilement de couches d'oxyde métallique avec des pourcentages atomiques de Zn, d'In et d'élément X adaptés et différents d'une couche à l'autre de l'empilement permettait de prévoir des températures de recuit réduites afin de rendre actif cet empilement, et qu'un composant électronique, en particulier un transistor formé d'un tel matériau soit fonctionnel, c'est à dire puisse suivre différents régimes de fonctionnement (linéaire, saturé) et adopter différents états (passant, bloqué) en fonction de la manière dont il est polarisé.

L'élément X peut être choisi parmi les éléments suivants : Ga, Sn, Sb, Be, Al, Ni.

Selon un mode de réalisation, la présente invention concerne un procédé de formation sur un substrat d'une zone active d'oxyde métallique pour dispositif électronique comprenant :
a) dépôt en phase liquide sur le substrat d'une première solution à base d'Indium, de Zinc et d'un élément X choisi parmi Ga, Sb, Be, Al, Ni, puis traitement thermique de manière à former une première couche en un premier oxyde métallique d'Inₐ₁X_{b1}Zn_{c1}O_{d1}, ayant une première fraction atomique en Indium, une première fraction atomique en élément X, une première fraction atomique en Zinc, telles que le premier oxyde métallique est plus riche en Indium et en élément X qu'en Zinc,
b) dépôt en phase liquide sur la première couche d'une deuxième solution à base d'Indium, de Zinc et de l'élément X, puis traitement thermique de manière à former une deuxième couche en un deuxième oxyde métallique d'Inₐ₂X_{b2}Zn_{c2}O_{d2}, ayant une deuxième fraction atomique en Indium, une deuxième fraction atomique en élément X, une deuxième fraction atomique en Zinc, telles que le deuxième oxyde métallique est plus riche en Zinc qu'en élément X, et plus riche en Zinc que le premier oxyde tout en étant moins riche en élément X que le premier oxyde,
c) dépôt en phase liquide sur la deuxième couche d'une troisième solution à base d'Indium, de Zinc et de l'élément X, puis traitement thermique de manière à former une troisième couche en un troisième oxyde métallique d'Inₐ₃X_{b3}Zn_{c3}O_{d3}, ayant une troisième fraction atomique en Indium, une troisième fraction atomique en élément X, une troisième fraction atomique en Zinc, le troisième oxyde étant plus riche en élément X que le deuxième oxyde tout en étant moins riche en élément Zinc que le deuxième oxyde.

Avantageusement, le troisième oxyde est plus riche en Indium qu'en élément X et qu'en Zn.

Selon un mode de réalisation particulier, le deuxième oxyde métallique est moins riche en Indium que le troisième oxyde.

Selon un mode avantageux, l'élément X peut être du Gallium.

Selon un mode de réalisation particulier, le premier oxyde métallique peut être de l'IGZO avec une première fraction atomique en Indium comprise entre 1 et 2, une première fraction atomique en Gallium comprise entre 0,5 et 1,5 (de préférence supérieure à 1), une première fraction atomique en Zinc comprise entre 0,5 et 1, le deuxième oxyde métallique étant de l'IGZO avec une deuxième fraction atomique en Indium comprise entre 0,5 et 1, une deuxième fraction atomique en Gallium comprise entre 0,1 et 0,5, une deuxième fraction atomique en Zinc comprise entre 1 et 2, le troisième oxyde métallique étant de l'IGZO avec une troisième fraction atomique en Indium comprise entre 1 et 3 (de préférence supérieure à 2), une troisième fraction atomique en Gallium comprise entre 0,4 et 0,6, une troisième fraction atomique en Zinc comprise entre 1 et 2.

Avec un tel procédé, on peut prévoir des températures de recuits réduites ce qui peut permettre d'utiliser le procédé avec un substrat polymère ou plastique.

Le ou les traitements thermiques réalisé(s) peut ou peuvent être effectué(s) à une température comprise entre 150 et 400°C.

Afin d'améliorer le recuit de la première couche, de la deuxième couche et de la troisième couche, le traitement thermique peut être accompagné d'un traitement photonique impulsionnel. Un tel type de traitement permet de ne pas détériorer le substrat dans la mesure où l'on limite son échauffement.

Avantageusement, le traitement thermique est accompagné d'émission d'une série d'impulsions de rayonnement UV.

Avantageusement, le substrat est en matériau polymère.

Avantageusement, la première couche est prévue avec une épaisseur comprise entre 1 et 15nm.

De même, la deuxième couche peut être prévue avec une épaisseur comprise entre 1 et 15nm.

La troisième couche peut être prévue avec une épaisseur comprise entre 1 et 15nm.

La séquence d'étapes a), b), c) peut être répétée un certain nombre k de fois (avec k un entier supérieur à 1) afin de former l'empilement.

Avantageusement, la première solution, la deuxième solution et la troisième solution sont mises en oeuvre à l'aide d'un procédé sol-gel.

Un procédé suivant l'invention est tout particulièrement adapté pour la mise en oeuvre de zones actives de transistors TFT. Ainsi, le dispositif électronique peut comprendre au moins un transistor TFT dont la zone de canal est formée dans ladite zone active.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un exemple de procédé de réalisation d'une solution liquide de dépôt pour former une couche d'oxyde métallique IXZO ;
- les figures 2A-2B servent à illustrer des exemples d'empilements de couches d'oxyde métallique en Indium, en Zinc et en un autre élément X tel que le Gallium et comportant des fractions atomiques respectives différentes en Indium, en élément X et en Zinc pour la mise en oeuvre d'une zone active d'un composant électronique suivant l'invention ;
- la figure 3 donne différentes courbes caractéristiques courant de canal en fonction de la tension de grille pour des transistors TFT comportant une zone active telle que mise en oeuvre suivant l'invention, les zones actives respectives étant obtenues pour différentes températures de recuit ;
- la figure 4 donne différentes courbes caractéristiques courant de canal en fonction de la tension de grille pour des transistors TFT comportant une zone active telle que mise en oeuvre suivant l'art antérieur, les zones actives respectives étant obtenues pour différentes températures de recuit ;
- la figure 5 sert à illustrer un exemple de structure de transistor TFT formé d'une zone active telle que mis en oeuvre suivant l'invention ;
- la figure 6 sert à illustrer un autre exemple de structure de transistor TFT formé d'une zone active telle que mis en oeuvre suivant l'invention ;
- les figures 7A-7C illustrent différentes configurations de particules de Gallium et de Zinc en fonction dans un matériau IGZO en fonction de la température de recuit ;

En outre, dans la description ci-après, des termes qui dépendent de l'orientation du dispositif s'appliquent en considérant que la structure est orientée de la façon illustrée sur les figures.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé de formation par voie liquide d'une première couche 9₁ d'oxyde métallique Inₐ₁X_{b1}Zn_{c1}0_{d1} à base d'Oxyde de Zinc, d'Indium et d'un autre élément X, sur un substrat va à présent être donné.

L'élément X est un élément choisi parmi les éléments suivants : Ga, Sb, Be, Al, Ni, Y, Sn, Si, Sn, Mg, Ag, Ca, Cu. Cet élément est choisi de préférence de sorte à avoir une affinité faible avec l'Oxygène tel que Sb, Be, Ni, Al, Ga. L'élément X peut être en particulier de l'antimoine (X=Sb), ou du gallium (X=Ga). Dans l'exemple de réalisation qui va à présent être décrit on choisit comme élément X du Gallium.

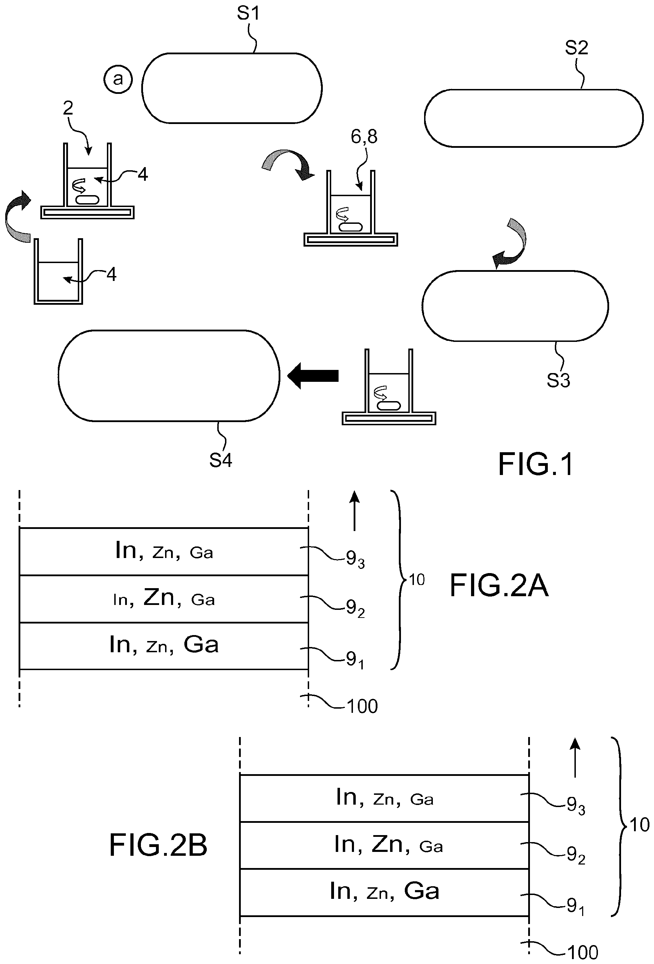

Cette première couche d'oxyde métallique est prévue pour former une zone active 10 comportant un empilement de plusieurs couches 9₁, 9₂, 9₃ d'oxyde métallique InₐX_{b}Z_{c}O_{d} ayant des pourcentages atomiques de Zn, d'In et d'élément X qui diffèrent d'une couche à l'autre de l'empilement (figure 1).

Par exemple, la première couche d'oxyde 9₁ est réalisée de sorte à avoir une première fraction atomique en Indium avec un premier pourcentage atomique en In appartenant à une première gamme, qui peut être par exemple comprise entre 1 et 2. La première couche 9₁ peut être également prévue avec une première fraction atomique en gallium ou un pourcentage atomique en gallium typiquement compris entre 0,5 et 1,5 (de préférence supérieure 1) et une première fraction atomique en Zn ou pourcentage atomique en Zn typiquement compris entre 0,5 et 1.

La fraction atomique en Indium et en Gallium peuvent être prévues supérieures et de préférence très supérieures à celle de Zinc par rapport à la composition moyenne c'est-à-dire la composition sans optimisation (classique). C'est à dire la concentration initiale, c'est celle qui est sous cette forme In₃Zn₂Ga_{0,4} donc la concentration en In = 3at%, Zn=2at%, Ga=0,4%, par conséquent l'In et le Ga sont supérieure à la valeur de In>2At% et Ga>0,4At% alors que Zinc est inférieure à 2At%.

La première couche d'oxyde métallique 9₁ peut être formée à l'aide d'un procédé de type sol-gel mettant en oeuvre un processus de polymérisation analogue à celui d'une polymérisation organique et utilisant des précurseurs en solution.

On emploie de préférence une solution liquide à base de sels métalliques plutôt qu'une autre voie de synthèse avec des composés organométalliques de type alcoxydes. Cette autre voie nécessiterait en effet la mise en oeuvre d'une atmosphère inerte et l'utilisation de températures élevées.

La solution comporte typiquement un chélateur tel que par exemple de l'acide citrique et un solvant, tel que le 2-méthoxyéthanol (ci-après appelé « 2ME »), adapté à la fois pour dissoudre les précurseurs et remplir la fonction d'agent réticulant.

On emploie en particulier comme précurseurs des sels métalliques comprenant des espèces cationiques In³⁺, Zn²⁺, Xⁿ⁺ avec Xⁿ⁺ par exemple Ga³⁺ et au moins une espèces anionique de type chlorure, nitrate, acétate.

Selon un mode de réalisation particulier, on utilise avantageusement des acétates qui présentent une bonne stabilité notamment parce qu'ils sont insensibles à la présence d'eau et, après décomposition, présentent comme avantage de former des oxydes électriquement stables. Les acétates permettent également de conduire à une meilleure reproductibilité du procédé.

L'espèce gallium peut être introduite sous forme d'acétylacétonate. L'indium peut quant à lui être introduit sous forme d'acétate d'indium. Une solution d'acide acétique, peut permettre de faciliter la dissolution de l'acétate d'indium dans le solvant 2ME.

Selon un exemple de synthèse de la première solution, celle-ci est formée à partir de 3 solutions A, B, C :
- la solution A contenant par exemple 0,2M d'Indium dans un solvant 2ME avec de l'acétate d'Indium ;
- la solution B contenant par exemple 0,4M de Zinc dans le 2ME avec l'acétate de zinc dihydraté ;
- la solution C contenant 0,02M d'acétylacétonate de gallium(III).

En variante, un autre élément X que le Gallium peut être utilisé pour former l'oxyde IGXO. Dans ce cas, la solution C peut être formée par exemple à partir d'un des composés choisis dans la liste suivante: acétate d'argent(II), acétate de palladium(II), acétate de cuivre(II), acétate de magnésium tetrahydraté, acétate de nickel(II) tetrahydraté, acétate de calcium hydrate, acétate de manganèse(II), acétate d'étain(II), acétate d'antimoine(III), acétate de molybdène(II), acétate d'aluminium, acétate d'yttrium(III) hydraté, acétate de béryllium.

La proportion entre le complexant et la solution peut être prévue par exemple à 1 pour 8, tandis que le rapport entre l'acide acétique et la solution peut par exemple être prévu à 1 pour 8.

Un exemple de procédé générique de synthèse de la première solution est illustré de manière schématique sur la figure 1.

Les précurseurs métalliques, en particulier sous forme d'acétates métalliques 2 sont tout d'abord dissouts (étape S1) dans un solvant 4 tel que par exemple le 2ME sous agitation et chauffage à une température par exemple de l'ordre de 50°C. La durée de l'agitation sous chauffage peut avoir une durée adaptée de préférence jusqu'à obtenir une solution d'aspect claire et limpide. Par exemple, on prévoit une durée d'agitation de l'ordre de 30 minutes.

Ensuite, pour former des complexes métalliques (étape S2) et stabiliser la solution afin d'éviter une précipitation, un premier agent 6 tel que de l'acide acétique est introduit dans un rapport molaire par exemple de 1 pour 8.

Puis, on ajoute un complexant 8 tel que de l'éthanolamine, dans un rapport molaire qui peut être également de 1 pour 8.

La solution est ensuite agitée à une température supérieure à la température ambiante par exemple de l'ordre de 70°C pendant une durée qui peut être de plusieurs heures jusqu'à obtenir une solution claire et homogène.

Concomitamment, une réaction de chélation s'opère autour des ions métalliques pour former des complexes métalliques. La vitesse d'hydrolyse peut être augmentée en mettant en oeuvre une catalyse acide. L'utilisation d'acide acétique permet en particulier de diminuer la durée d'un processus de gélification. Une réaction exothermique a alors lieu lorsque l'acide acétique est ajouté. Une solution d'aspect limpide peut être alors obtenue.

On peut ensuite ajouter une base telle que l'éthanolamine pour permettre de décaler la réaction vers un milieu basique (étape S3). La liaison (C=N) de l'éthanolamine permet de produire un ligand complexe très stable avec les ions métalliques.

Simultanément à la complexation, la polymérisation commence pour former des macromolécules qui se lient entre elles afin d'obtenir un précurseur polymérique. La réaction de polymérisation est généralement une réaction lente qui peut nécessiter une durée supérieure à 12h pour être complétement réalisée.

Une réaction à une température supérieure à la température ambiante (par exemple de l'ordre de 70°C) est effectuée sous agitation. La durée de gélification peut varier entre plusieurs minutes et plusieurs jours. Une telle durée peut être attribuée à la capacité de complexation du ligand acétate.

On peut ensuite laisser reposer la première solution pendant une durée de l'ordre de 12h par exemple, avant que celle-ci ne soit prête à être déposée sur un substrat.

Ensuite, la solution est prélevée à l'aide d'un dispositif de prélèvement, par exemple tel qu'une micropipette afin d'être déposée sur un substrat préalablement nettoyé. Ce dépôt est réalisé à la tournette, suivi d'un recuit de la couche. Le recuit peut être réalisé à une température de 450°C sous air.

Le dépôt (étape S4) de la première solution peut être ensuite réalisé sur un substrat 100 par dépôt à la tournette (« spin coating » selon la terminologie anglo-saxonne), le substrat étant lui-même disposé sur un support tournant.

Typiquement, ce dépôt peut être effectué en deux phases : une première dite à « faible » vitesse du support tournant pour réaliser un étalement de la solution. Puis, une deuxième à une vitesse plus élevée est réalisée afin d'obtenir une couche homogène.

Les paramètres de durée et de vitesse de mise en rotation du support tournant sont choisies en fonction du type de substrat 100 sur lequel on réalise le dépôt afin d'obtenir une couche d'épaisseur la plus uniforme possible tout en limitant le nombre de défauts.

Par exemple, lorsque le substrat 100 est en verre, on effectue une première phase du dépôt à une vitesse de préférence faible, par exemple de 500 tours par minute pendant une durée par exemple de l'ordre de 5s, puis une deuxième phase du dépôt à vitesse plus élevée qui peut être par exemple de l'ordre de 1500 tours par minute pendant une durée plus importante par exemple de l'ordre de 30s.

La première couche 9₁ d'Inₐ₁X_{b1}Zn_{c1}O_{d1} a une épaisseur qui peut être de plusieurs nanomètres, par exemple entre 1 et 15 nanomètres, typiquement inférieure ou égale à 5nm et par exemple de l'ordre de 2nm.

Le dépôt est suivi d'au moins un recuit ou traitement thermique permettant de sécher et d'éliminer des éléments volatils et de décomposer les précurseurs ou résidus organiques.

Les caractéristiques physiques de la couche d'Inₐ₁X_{b1}Zn_{c1}O_{d1} ainsi réalisée dépendent des conditions de montée en température et de l'environnement gazeux lors de ce traitement thermique. La décomposition des précurseurs organiques s'effectue selon la température mais aussi en fonction de l'épaisseur liquide au départ, plus l'épaisseur liquide est importante plus la montée en température et la durée sont importantes.

Un tel traitement thermique peut être effectué à une température comprise entre 150°C et 450°C par exemple de l'ordre 300°C. Le traitement thermique est avantageusement accompagné ou réalisé à l'aide d'un traitement photonique impulsionnel, lors duquel des impulsions de rayonnement UV sont émises, ces impulsions ayant une durée qui peut être comprise par exemple entre 0.001 ms et 2 ms avec une énergie qui peut être de l'ordre de 2000 Joules.

Ensuite, après réalisation de la première couche 9₁, on forme sur la première couche d'oxyde métallique 9₁ une deuxième couche 9₂ d'oxyde métallique Inₐ₂X_{b2}Zn_{c2}O_{d2} avec des pourcentages atomiques de Zn, d'In et de Gallium qui diffèrent de ceux de la première couche 9₁. La deuxième couche 9₂ peut être réalisée d'une manière telle que décrite précédemment, les quantités de précurseurs dans les solutions A, B, C étant adaptées afin d'obtenir les fractions atomiques recherchées.

La deuxième couche 9₂ est prévue avec une fraction atomique en Indium, une fraction atomique en Gallium, une fraction atomique en Zinc, de sorte à être plus riche en Zinc qu'en Gallium. La deuxième couche 9₂ est également plus riche en Zinc que la première couche 9₁. La deuxième couche 9₂ peut être également moins riche en Gallium que la première couche 9₁.

Par exemple la deuxième couche d'oxyde 9₂ est réalisée de sorte à avoir une deuxième fraction atomique en Indium avec un deuxième pourcentage atomique en In appartenant à une gamme, qui peut être par exemple comprise entre 0,5 et 1 (préférentiellement égale à 1). La deuxième couche 9₂ peut être également prévue avec une deuxième fraction atomique en gallium ou un pourcentage atomique en gallium typiquement compris entre 0,1 et 0,5 (préférentiellement 0,4) et une deuxième fraction atomique en Zn ou pourcentage atomique en Zn typiquement compris entre 1 et 2 (préférentiellement égale à 2)

La deuxième couche 9₂ d'Inₐ₂X_{b2}Zn_{c2}O_{d2} a une épaisseur qui peut être prévue de l'ordre de plusieurs nanomètres, par exemple entre 1 et 15 nanomètres, typiquement inférieure ou égale à 5nm et par exemple de l'ordre de 2nm.

Le dépôt de la deuxième couche 9₂ est également suivi d'au moins un recuit ou traitement thermique. Le recuit ou traitement thermique peut être réalisé à une température comprise entre 150°C et 450°C, par exemple de l'ordre de 300°C.

Ensuite, on forme sur la deuxième couche d'oxyde métallique 9₂ une troisième couche 9₃, d'oxyde métallique Inₐ₃X_{b3}Zn_{c3}O_{d3} ayant des pourcentages atomiques de Zn, d'In et en Gallium qui diffèrent de ceux de la première couche 9₁ et de la deuxième couche 9₂. La troisième couche 9₃ peut être également réalisée de la manière telle que décrite précédemment pour la première couche ou la deuxième couche, en adaptant les concentrations molaires de la solution de dépôt.

La troisième couche 9₃ est prévue avec une troisième fraction atomique en Indium, une troisième fraction atomique en Gallium, une troisième fraction atomique en Zinc. La troisième couche 9₃ peut par exemple être plus riche en Indium qu'en Gallium et qu'en Zinc. La troisième couche 9₃ peut être également plus riche en Gallium que la deuxième couche 9₂. On prévoit également de préférence la troisième couche 9₃ moins riche en élément Zinc que la deuxième couche 9₂.

Par exemple, la troisième couche d'oxyde 9₃ est réalisée de sorte à avoir une troisième fraction atomique en Indium avec un premier pourcentage atomique en In appartenant à une gamme, qui peut être par exemple comprise entre 1 et 3 (préférentiellement supérieure à 2). La troisième couche 9₃ peut être également prévue avec une troisième fraction atomique en gallium ou un pourcentage atomique en gallium typiquement compris entre 0,4 et 0,6 (préférentiellement 0,4) et troisième une fraction atomique en Zn ou pourcentage atomique en Zn typiquement compris entre 1 et 2 (préférentiellement 1,5).

La troisième couche 9₃ d'Inₐ₃X_{b3}Z_{c3}O_{d3} a une épaisseur qui peut être prévue de l'ordre de plusieurs nanomètres, par exemple entre 1 et 15 nanomètres, de préférence inférieure ou égale à 5 nm, par exemple de l'ordre de 2 nm.

Le dépôt de la troisième couche 9₃ est également suivi d'au moins un recuit ou traitement thermique. Le recuit ou traitement thermique peut être réalisé à une température comprise entre 150°C et 450°C, par exemple de l'ordre de 300°C.

On peut prévoir de répéter l'empilement de trois couches précédemment décrit, par exemple k fois (k étant un entier supérieur à 1), ce afin de réaliser sur un substrat 100 une zone active 10 d'épaisseur finale qui peut être comprise par exemple entre 10 et 100nm.

Pour cela, la séquence d'étapes décrite précédemment peut être répétée k fois.

Un exemple d'empilement d'au moins 3 couches 9₁, 9₂, 9₃ du type de telles que décrites précédemment est donné sur la figure 2A, sur laquelle la taille des symboles chimiques des différents composants est représentative d'une fraction atomique, plus la taille d'un symbole représentatif d'un élément chimique étant importante plus sa fraction atomique dans l'oxyde étant importante. Inversement plus la taille d'un symbole représentatif d'un élément chimique est faible plus sa fraction atomique dans l'oxyde est faible.

On a ainsi formé la première couche 9₁ à partir d'une solution telle que [In] ≥ [Ga]>>[Zn] (la notation [.] correspondant à une concentration d'un élément donné, et « ≥ » et « >> » signifiant, respectivement, supérieur ou égale et très supérieur). La deuxième couche 9₂ a été formée à partir d'une solution telle que [Zn]≥ [In]>>[Ga]. La troisième couche 9₃ a été formée à partir d'une solution telles que [In]≥ [Ga] et [In]≥[Zn].

Dans cet exemple, la fraction atomique en Indium dans la deuxième couche 9₂ peut être inférieure à celle des première couche 9₁ et troisième couche 9₃. La fraction atomique en Zinc dans la deuxième couche 9₂ peut être supérieure aux fractions atomiques en Zn dans la première couche 9₁ et la troisième couche 9₃. La fraction atomique en Gallium dans la deuxième couche 9₁ peut être supérieure aux fractions atomiques en Gallium dans la deuxième couche 9₂ et la troisième couche 9₃.

Une variante de réalisation de l'empilement de couches 9₁, 9₂, 9₃ est illustrée sur la figure 2B. Pour cette variante, on prévoit la mise en oeuvre d'une zone active comportant une première couche d'oxyde 9₁, une deuxième couche d'oxyde 9₂ et une troisième couche d'oxyde 9₃ réalisées de sorte à avoir des fraction atomiques respectives en Indium « élevées ». Par « élevée en Indium » on entend par exemple entre 2 et 3.

Pour cette variante, la première couche 9₁, la deuxième couche d'oxyde 9₂ et la troisième couche d'oxyde 9₃ peuvent être prévues avec des fractions atomiques respectives « élevée » en Ga « faible » en Ga et « moyenne » en Ga. Par « élevée en Ga », on entend par exemple entre 0,6 et 0,8. Par « faible en Ga », on entend par exemple entre 0,1 et 0,4. Par « moyenne en Ga », on entend par exemple entre respectivement entre 0,4 et 0,6.

La première couche 9₁, la deuxième couche d'oxyde 9₂ et la troisième couche d'oxyde 9₃ peuvent être prévues avec des fractions atomiques respectives en Zn, « faible » en Zn, « élevée » en Zn et « moyenne » en Zn. Par « faible en Zn » on entend par exemple entre 0,5 et 1. Par « élevée en Zn », on entend par exemple entre 2 et 3, et par « moyenne en Zn », on entend par exemple entre 1 et 2.

Un exemple particulier de mise en oeuvre de zone active de transistor TFT suivant l'invention est formée d'un empilement d'au moins trois couches d'oxyde métallique d'IGZO avec des fractions atomiques d'In, de Ga, de Zn, différentes entre elles, et une fraction atomique d'Indium différente d'une couche à l'autre de l'empilement et en particulier croissante lorsque l'empilement est pris en s'éloignant du substrat 100.

Dans cet exemple de réalisation particulier, et relatif à la figure 2A, la première couche d'oxyde métallique a des pourcentages atomiques en In, Ga, Zn respectivement de 3, 0.8, 1, tandis que la deuxième couche d'oxyde métallique, reposant sur la première couche, a des pourcentages atomiques en In, Ga, Zn respectivement de 1, 0.4, 2. La troisième couche d'oxyde métallique, reposant sur la deuxième couche, est quant à elle prévue avec des pourcentages atomiques en In, Ga, Zn respectivement de 3, 0.4,1.

Dans un autre exemple de réalisation particulier, la première couche d'oxyde métallique a des pourcentages atomiques en In, Ga, Zn respectivement de 1.5, 0.8, 0.5, tandis que la deuxième couche d'oxyde métallique, reposant sur la première couche, a des pourcentages atomiques en In, Ga, Zn respectivement de 3, 0,4, 2. La troisième couche d'oxyde métallique, reposant sur la deuxième couche, est quant à elle prévue avec des pourcentages atomiques en In, Ga, Zn respectivement de 3, 0.4, 1.

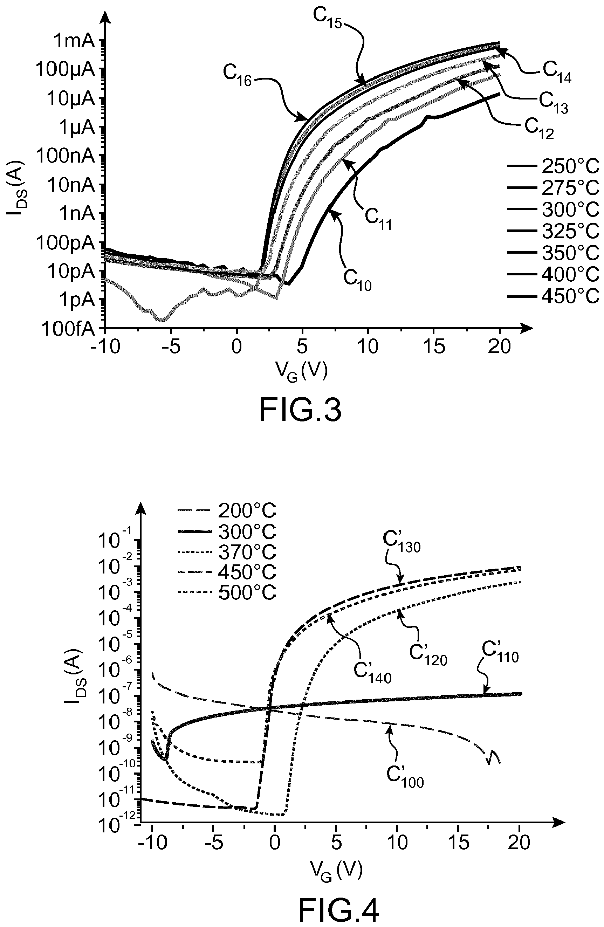

La figure 3 donne différentes courbes C₁₀, C₁₁, C₁₂, C₁₃, C₁₄, C₁₅, C₁₆ caractéristiques Ids = f(Vg), de courant de canal en fonction de la tension de grille d'un transistor TFT dont la zone active a une composition identique à celle de l'exemple particulier relatif à la figure 2A. Ces courbes caractéristiques sont représentatives de performances de zones actives obtenues pour différentes températures de recuit, respectivement de 250°C, 275°C, 300°C, 325°C, 350°C, 400°C, 450°C.

On constate que pour une température de recuit de 250°C ou de 300°C on obtient un transistor fonctionnel. La mise en oeuvre de l'empilement de couches d'oxydes de compositions différentes permet de limiter la température de recuit nécessaire à l'obtention d'une zone active fonctionnelle dont la conductivité peut être modulée par la grille pour permettre de conférer au transistor différents un régime de fonctionnement et un état parmi plusieurs régimes de fonctionnement et d'états possibles.

A titre de comparaison, la figure 4 donne différentes courbes C'₁₀₀, C'₁₁₀, C'₁₂₀, C'₁₃₀, C'₁₄₀, caractéristiques Ids = f(Vg), de courant de canal en fonction de la tension de grille d'un transistor suivant l'art antérieur. Ce transistor comporte une seule couche d'IGZO de 5 nm d'épaisseur avec des concentrations atomiques en Indium, Gallium, et Zinc respectivement de 3, 0.4, 2, ce pour différentes températures de recuit pour former la zone active, respectivement de 200°C, 300°C, 370°C, 450°C, 500°C. On constate des recuits thermiques à 200°C et 300°C ne sont pas suffisants pour permettre de rendre la zone d'IGZO active et le transistor TFT fonctionnels.

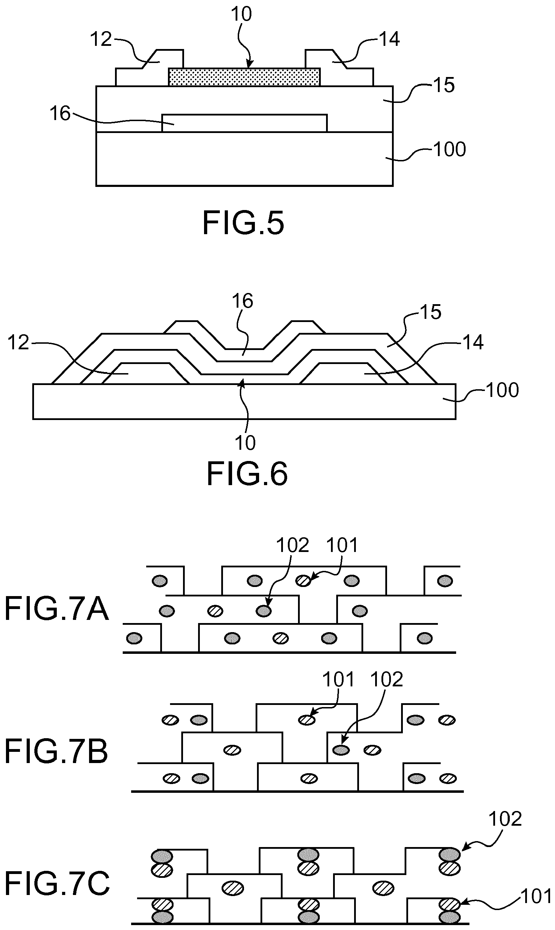

Un exemple de structure de transistor intégrant une zone active 10 formée d'une manière telle que décrite précédemment à base d'un empilement de couches d'oxydes métalliques de compositions différentes est illustrée sur la figure 5.

Dans cet exemple, le transistor est doté d'une grille 16 en configuration de type appelé « grille haute » ou « grille dessus » (en anglais : « top gâte »). L'électrode de grille 16 est ainsi disposée sur la couche active 10 et permet de commander une zone de canal réalisée dans cette couche 10 et qui est disposée entre les électrodes 12 et 14 de source et de drain, et située en regard de l'électrode de grille 16.

Le transistor est formé sur un substrat 100 qui peut être semi-conducteur et par exemple en silicium ou à base d'un matériau transparent tel que du verre.

Avantageusement, le substrat 100 est en un matériau élastique, en particulier un matériau polymère par exemple tel que du polyimide (PI) ou du polyétheréthercétone (PEEK) ou du Polyarylate (PAR) ou PEI (Polyétherimide).

Dans cet exemple de réalisation, la zone active 10 est surmontée d'une couche 15 de diélectrique de grille, par exemple une couche à base de polystyrène de 200 nm d'épais tandis qu'une électrode de grille 16, par exemple à base de d'argent de 50 nm d'épaisseur repose sur la couche de diélectrique 15, et est ainsi située au-dessus des électrodes de source 12 et de drain 14.

Un autre exemple de structure de transistor intégrant une couche active 10 telle que décrite précédemment est illustré sur la figure 6 avec cette fois une configuration de type appelé « grille basse ». La grille 16 est ainsi disposée sous la couche active 10 et sous les électrodes de source 12 et de drain 14.

Selon une autre variante de réalisation (non représentée) on intègre la couche active 10 dans une structure coplanaire qui, à la différence des structures empilées décrites précédemment, prévoit un agencement des trois électrodes 12, 14, 16 d'un même côté de la couche active 10.

Pour permettre de caractériser une zone active à base d'oxyde métallique, par exemple une zone formée d'un empilement d'oxydes de fractions atomiques différentes et telle que mise en oeuvre à l'aide d'un procédé tel que décrit précédemment une méthode de diffraction de rayons X à petits angles et à incidence rasante (GISAXS pour (« grazing-incidence small-angle X-ray scattering ») peut être employée. Cette méthode permet d'obtenir des informations morphologiques ou encore de caractériser la structure interne la zone active.

Cette méthode met, en particulier, en évidence un ordre dans une distribution de pores dans la zone active, qui évolue en fonction de la température de recuit.

Une telle méthode montre que la distance entre les pores augmente de plusieurs nanomètres lorsque la température de recuit augmente par exemple de 300°C à 450°C.

En plus d'une mise en évidence d'une corrélation spatiale dans la disposition des pores dans une zone d'IGZO recuite, l'analyse par méthode GISAXS, en particulier en mode anomale (AGISAXS), peut permettre également d'appréhender la disposition locale des atomes du matériau à base d'IGZO.

Pour permettre de décrire l'arrangement et les liens qu'entretiennent les trois oxydes d'Indium, de Zinc et de Gallium élémentaires dans le matériau de la zone active, des mesures aux petits angles à plusieurs énergies de rayons X en incidence rasante anomale de l'élément à analyser peuvent être réalisés.

L'analyse d'images obtenues par méthode AGISAXS montre l'apparition de régions riches en Zn et celles des régions riches en Ga dans les couches d'IGZO recuits à des températures différentes et permettent de montrer qu'il y a une auto-organisation de nano-amas inorganiques dans les couches minces d'IGZO qui sont fonction de la température de recuit. La technique AGISAXS sonde la structure d'une couche d'IGZO aussi bien dans la direction parallèle que dans celle perpendiculaire au substrat. Des pores sont créés spontanément lorsque la solution d'IGZO est recuite à une certaine température comme indiqué précédemment. Les nanoparticules ordonnées provenant de la séparation de phases des différents oxydes sont mises en évidence grâce à l'apparition de pics d'interférences signifiant une distance préférentielle entre les nanoparticules sondées.

Les figures 7A-7C illustrent de manière schématique l'agencement, tel que révélé par la méthode d'analyse AGISAXS de nanoparticules 101 de Zn et de nanoparticules 102 de Ga dans un oxyde métallique IGZO, pour différentes températures de recuit. Pour une température de recuit au-dessus de 300°C (figures 7A-7B), certains produits organiques résiduels de la solution de dépôt s'évaporent, ce qui donne ainsi un réseau poreux. Entre temps, les oxydes métalliques s'organisent avec l'émergence d'amas sous forme de nanoparticules à une distance dans le plan de la couche d'oxyde ayant une périodicité liée à celle du réseau poreux. Lorsque la température de recuit atteint 450°C (figure 7C), la distance entre des zones riches de Zn est égale à celle des zones riches de Ga, de même égale à la distance moyenne entre les pores.

Une autre méthode d'analyse du matériau de la zone active peut utiliser un équipement de spectrométrie de diffusion d'ion à moyenne énergie (MEIS).

L'équipement MEIS utilisé peut employer comme particule incidente de l'hélium à une énergie de 100keV.

D'une manière générale, la mesure par spectroscopie MEIS peut permettre d'établir ou vérifier la stoechiométrie de l'oxyde métallique en fonction de la perte d'énergie, c'est-à-dire en fonction de la quantité de matière traversée et donc du produit « densité totale de matière » par « épaisseur». Pour remonter aux épaisseurs des couches, on peut faire une hypothèse sur la densité totale.

Pour de l'IGZO avec des fractions d'In à 30%, de Ga à 5%, de Zn à 18%, et d'Oxygène à 48%, on peut prendre par exemple comme hypothèse de densité une densité constante égale à celle d'IGZO massif amorphe de 6,1 g/cm-³.

Les données structurales des analyses peuvent être utilisées pour obtenir des grandeurs fondamentales, comme la taille des domaines des oxydes élémentaires qui constituent l'oxyde métallique IGZO, la taille des pores, ainsi que la position des oxydes dans les trois dimensions.

## Revendications

1. Procédé de formation sur un substrat d'une zone active d'oxyde métallique pour dispositif électronique comprenant :
a) dépôt en phase liquide sur le substrat d'une première solution à base d'Indium, de Zinc et d'un élément X choisi parmi Ga, Sb, Be, Al, Ni, puis traitement thermique de manière à former une première couche en un premier oxyde métallique d'Inₐ₁X_{b1}Zn_{c1}O_{d1}, ayant une première fraction atomique en Indium, une première fraction atomique en élément X, une première fraction atomique en Zinc, telles que le premier oxyde métallique est plus riche en Indium et en élément X qu'en Zinc,
b) dépôt en phase liquide sur la première couche d'une deuxième solution à base d'Indium, de Zinc et de l'élément X, puis traitement thermique de manière à former une deuxième couche en un deuxième oxyde métallique d'Inₐ₂X_{b2}Zn_{c2}O_{d2}, ayant une deuxième fraction atomique en Indium, une deuxième fraction atomique en élément X, une deuxième fraction atomique en Zinc, telles que le deuxième oxyde métallique est plus riche en Zinc qu'en élément X, et plus riche en Zinc que le premier oxyde tout en étant moins riche en élément X que le premier oxyde,
c) dépôt en phase liquide sur la deuxième couche d'une troisième solution à base d'Indium, de Zinc et de l'élément X, puis traitement thermique de manière à former une troisième couche en un troisième oxyde métallique d'Inₐ₃X_{b3}Zn_{c3}O_{d3}, ayant une troisième fraction atomique en Indium, une troisième fraction atomique en élément X, une troisième fraction atomique en Zinc, le troisième oxyde étant plus riche en élément X que le deuxième oxyde tout en étant moins riche en élément Zn que le deuxième oxyde.

2. Procédé selon la revendication 1, dans lequel le troisième oxyde est plus riche en Indium qu'en élément X et qu'en Zn.

3. Procédé selon la revendication 2, dans lequel le deuxième oxyde métallique est moins riche en Indium que le troisième oxyde.

4. Procédé selon l'une des revendications 1 à 3, dans lequel l'élément X est du Gallium, le premier oxyde métallique étant de l'IGZO avec une première fraction atomique en Indium comprise entre 1 et 2, une première fraction atomique en Gallium comprise entre 0,5 et 1,5, une première fraction atomique en Zinc comprise entre 0,5 et 1, le deuxième oxyde métallique étant de l'IGZO avec une deuxième fraction atomique en Indium comprise entre 0,5 et 1, une deuxième fraction atomique en Gallium comprise entre 0,1 et 0,5, une deuxième fraction atomique en Zinc comprise entre 1 et 2, le troisième oxyde métallique étant de l'IGZO avec une troisième fraction atomique en Indium comprise entre 1 et 3, une troisième fraction atomique en Gallium comprise entre 0,4 et 0,6, une troisième fraction atomique en Zinc comprise entre 1 et 2.

5. Procédé selon l'une des revendications 1 à 4, dans lequel le traitement thermique est réalisé à une température comprise entre 150 et 450°C.

6. Procédé selon la revendication 5, dans lequel traitement thermique est accompagné d'émission d'une série d'impulsions de rayonnement UV.

7. Procédé selon l'une des revendications 1 à 6, dans lequel le substrat est en matériau polymère.

8. Procédé selon l'une des revendications 1 à 7, dans lequel la première couche, la deuxième couche et la troisième couche ont une épaisseur comprise entre 1 et 15nm.

9. Procédé selon l'une des revendications 1 à 8, dans lequel la séquence d'étapes a), b), c) est répétée k fois, avec k un entier supérieur à 1.

10. Procédé selon l'une des revendications 1 à 9, dans lequel la première solution, la deuxième solution et la troisième solution sont mises en oeuvre à l'aide d'un procédé sol-gel.

11. Procédé selon l'une des revendications 1 à 10, dans lequel le dispositif électronique comprenant au moins un transistor TFT dont la zone de canal est formée dans ladite zone active.
